Europäisches Patentamt

European Patent Office

Office européen des brevets

(19)

(11) EP 1 737 130 A1

(12) EUROPÄISCHE PATENTANMELDUNG

(43) Veröffentlichungstag:
27.12.2006 Patentblatt 2006/52

(51) Int Cl.:
*H03K 17/95* (2006.01)

(21) Anmeldenummer: 06115193.2

(22) Anmeldetag: 09.06.2006

(84) Benannte Vertragsstaaten:
AT BE BG CH CY CZ DE DK EE ES FI FR GB GR
HU IE IS IT LI LT LU LV MC NL PL PT RO SE SI
SK TR
Benannte Erstreckungsstaaten:
AL BA HR MK YU

(30) Priorität: 15.06.2005 DE 102005027673

(71) Anmelder: SIEMENS AKTIENGESELLSCHAFT
80333 München (DE)

(72) Erfinder: Schmitt, Manfred
92256 Hahnbach (DE)

(54) **Näherungsschalter mit metallartunabhängigem Schaltabstand**

(57) Erfindungsgemäß wird ein Näherungsschalter geschaffen mit dem ein von der Metallart des Auslösers unabhängiger Schaltabstand erreicht wird. Hierzu weist der Näherungsschalter einen freischwingenden Oszillator mit einem LC-Schwingkreis auf, in dem zwei einen Spannungsteiler bildende Spulen (12, 13) einem Kondensator (4) parallel geschaltet sind. Der Mittenspannungsabgriff der Spulen (12, 13) ist mit einem Verstärker (8) verbunden, der ausgangsseitig über ein gegenüber dem Ersatzparallelwiderstand (14) des LC-Schwingkreises niederohmiges Rückkoppelelement (11) mit dem LC-Schwingkreis rückgekoppelt ist.

FIG 3

**Beschreibung**

Die Erfindung betrifft einen berührungslos arbeitenden Näherungsschalter mit einem Oszillator, der einen Parallelschwingkreis sowie einen nachgeschalteten Verstärker aufweist.

Induktive Näherungsschalter werden in großen Stückzahlen in der Automatisierungstechnik eingesetzt. Die Funktion des überwiegenden Teiles dieser Sensoren beruht auf der Bedämpfung eines LC-Schwingkreises. Da die Stärke der Bedämpfung von der Metallart abhängig ist, ergeben sich entsprechend unterschiedliche Schaltpunkte. Die Anwender fordern jedoch zwischenzeitlich vermehrt Sensoren mit metallartunabhängigen Schaltabständen, d.h. mit einem Korrekturfaktor = 1.

Diverse Funktionsprinzipien von Näherungsschaltern mit einem Korrekturfaktor = 1 sind bereits bekannt.

In der DE 403 12 52 wird ein Näherungsschalter beschrieben, dessen Sensoranordnung unter anderem aus drei hintereinander angeordneten Spulen besteht. Die mittlere Spule wirkt dabei als Sender und wird von einem Verstärker gespeist, an dessen Eingang die induzierte Differenzspannung der beiden Empfängerspulen anliegt. Durch Einbringung eines leitfähigen Auslösers in das Wechselfeld werden im Auslöser Ringströme hervorgerufen, die ihrerseits ein Gegenfeld aufbauen, das sich dem Feld der Sendespule überlagert. Dieses Gegenfeld, welches von der Metallart des Auslösers unabhängig ist, beeinflusst die näher liegende Empfängerspule stärker als die weiter entfernte in der Art, dass bei gewünschtem Ansprechabstand die Differenzspannung zu Null wird und dadurch die Schwingung abreißt.

Die DE 39 19 916 beschreibt einen Näherungsschalter, dessen Oszillatorschwingkreis lose an den Sensorschwingkreis angekoppelt ist. Durch entsprechende Auslegung der beiden Schwingkreise lassen sich auch hier für ferromagnetische und nichtferromagnetische Betätigungselemente gleiche Schaltabstände erzielen.

Aus der DE 43 30 140 ist ein induktiver Näherungsschalter bekannt, der zur Erreichung des Korrekturfaktors = 1 zwei Schwingkreise mit unterschiedlichen Resonanzfrequenzen verwendet, die über einen Widerstand miteinander gekoppelt sind.

Nachteilig bei dem vorgenannten Näherungsschalter ist der hohe konstruktive und elektrische Aufwand für mehrere Spulen bzw. Schwingkreise und deren Abstimmung aufeinander.

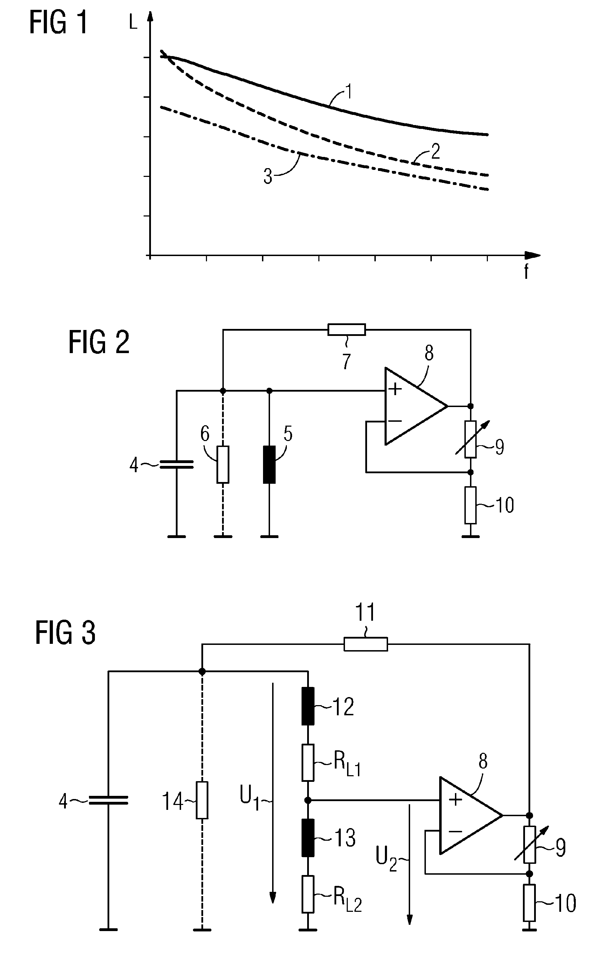

Weiterhin sind Standard-Oszillatoren (FIG 2) mit Korrekturfaktor $\neq$ 1 bekannt (siehe Fachbuch von Tietze-Schenk, 1983, Seite 441, Abb. 15.2) die üblicherweise aus einem LC-Schwingkreis mit einem Kondensator 4 und einer Spule 5, einem Verstärker 8 und einem Rückkoppelelement 7 bestehen. Der Verstärker 8 hat eine Verstärkung, die über das Verhältnis zweier Widerstände 9, 10 einstellbar ist. Hat der Widerstand 9 den Widerstandswert $R_A$ und der Widerstand 10 den Widerstandswert $R_B$, so ergibt sich die Verstärkung zu $V = (R_A + R_B)/R_B$.

Bei der Resonanzfrequenz wird die Schwingkreisimpedanz reell, d.h. der Imaginärteil ist Null, und kann als Ersatzparallelwiderstand 6 mit dem Widerstandswert $R_P$ angegeben werden, der mit abhängig ist von der Bedämpfung durch den Betätiger. Der Rückkoppelwiderstand 7 mit dem Widerstandswert $R_K$ und der Ersatzparallelwiderstand 6 bilden dabei einen Spannungsteiler. Solange das Verhältnis $R_A/R_B \geq R_K/R_P$ ist, schwingt die Oszillatorstufe. Bei Werten $R_A/R_B < R_K/R_P$ reißt die Schwingung ab. Von den Zuständen "schwingt" bzw. "schwingt nicht" lässt sich sehr einfach ein Schaltsignal ableiten. Die Bedämpfung ist von der Metallart des Betätigers abhängig. Daher ergeben sich unterschiedliche Schaltabstände. Für eine ausreichend hohe Ansprechempfindlichkeit werden Spulen mit hohen Güten, d.h. hohem Rp-Wert verwendet. Dementsprechend hochohmig ist auch der Rückkoppelwiderstand 7.

Aufgabe der vorliegenden Erfindung ist es, einen Näherungsschalter derart auszubilden, dass mit geringem konstruktiven und elektrischen Aufwand ein von der Metallart des Auslösers unabhängiger Schaltabstand (Korrekturfaktor = 1) erreicht wird.

Die Aufgabe wird durch einen Näherungsschalter mit den Merkmalen nach Anspruch 1 gelöst.

Ein Ausführungsbeispiel der Erfindung wird im Folgenden anhand einer Zeichnung näher erläutert. Es zeigen:

FIG 1    ein Diagramm mit den Induktivitätitsverläufen einer Spule für den unbeeinflussten Fall, für den Fall eines ferromagnetischen Auslösers und eines nichtferromagnetischen Auslösers und

FIG 3    eine Oszillatorschaltung des erfindungsgemäßen Näherungsschalters.

In der FIG 1 sind über die Frequenz f die Verläufe der Induktivität L einer Spule für den unbeeinflussten Fall 1, für den Fall eines ferromagnetischen Auslösers 2 und eines nichtferromagnetischen Auslösers 3 dargestellt. Die Erfindung nutzt die physikalische Eigenschaft, dass bei höheren Frequenzen (> 0,5 MHz) die Induktivitätsänderung durch die Gegeninduktion des Auslösers bei ferromagnetischen und nichtferromagnetischen Betätigern in etwa gleich ist.

FIG 3 zeigt einen freischwingenden Oszllator des erfindungsgemäßen Näherungsschalters. Er weist einen LC-Schwingkreis aus einem Kondensator 4 und einer dazu parallel geschalteten Reihenschaltung aus zwei Spulen 12 und 13 auf, wobei der Kondensator 4 die Kapazität C und die Spulen 12, 13 die Induktivitäten $L_1$ und $L_2$ aufweisen. Die Spulen 12, 13 sind verlustbehaftet und haben jeweils einen Ersatzwiderstand $R_{L1}$, $R_{L2}$.

Von den zwei nichtmagnetisch gekoppelten Teilspulen 12, 13 ist nur eine, z.B. die Spule 13, durch einen Betätiger beeinflussbar. Der Mittenspannungsabgriff zwischen den beiden Spulen ist an einen Verstärker 8 geführt, dessen Verstärkung wie bereits im Stand der Technik über das Verhältnis der Widerstände 9 und 10 einstellbar ist. Auch hier ist die Verstärkung durch die Widerstandswerte $R_A$ des Widerstands 9 und $R_B$ des Widerstands 10 definiert. Die Verstärkung ergibt sich zu $V = (R_A + R_B)/R_B$. Ein Rückkoppelelement 11 mit dem Impedanzwert $Z_K$ ist vom Verstärker 8 an den Schwingkreis rückgeführt.

Die beiden Teilspulen 12 und 13 bilden einen Spannungsteiler, wobei die Spannung $U_2$ an der Teilspule 13 zur Spannung $U_1$ über beide Teilspulen 12, 13 wie folgt definiert ist:

$$U_2/U_1 = (R_{L2} + j\,\omega\,L_2)/(R_{L1}+R_{L2}+j\,\omega\,(L_1+L_2))$$

Hierbei stellen die Ersatzwiderstände $R_{L1}$ und $R_{L2}$ die ohmschen Verluste der Spulen 12, 13 dar.
Bei hohen Frequenzen ($\omega L \gg R$) können diese Widerstände in der Spannungsteilerformel vernachlässigt werden und sie vereinfacht sich zu

$$U_2/U_1 = L_2/(L_1 + L_2).$$

Legt man zusätzlich das Rückkoppelelement 11 mit dem Impedanzwert $Z_K$ entsprechend niederohmig gegenüber dem Ersatzparallelwiderstand 14 (Widerstandswert $R_P$') des LC-Schwingkreises aus, d.h. $Z_K \ll R_P$', so entsteht eine Oszillatorschaltung, deren Schwingbedingung in erster Näherung nur noch vom Induktivitätsverhältnis $L_1/L_2$, d.h. nahezu metallartunabhängig und nicht mehr von den ohmschen Verlusten abhängig ist. Bei Werten von $R_A/R_B \geq L_1/L_2$ schwingt die Oszillatorschaltung, beim Verhältnis $R_A/R_B < L_1/L_2$ reißt die Schwingung ab. Somit lässt sich wie bei den Standardsensoren der Schaltpunktabgleich in einfacher Weise über das Verhältnis der Widerstände $R_A/R_B$ der Verstärkerstufe 8 durchführen.
FIG 1 zeigt, dass auch bei hohen Frequenzen ein geringer Restunterschied der Induktivitätsänderungen durch einen ferromagnetischen und einen nichtferromagnetischen Auslöser verbleibt. Durch geeignete Dimensionierung des Rückkoppelelements 11 kann jedoch erreicht werden, dass die Schaltabstände praktisch identisch sind.
Durch die erfindungsgemäße Sensoranordnung lassen sich auf einfache und kostengünstige Weise induktive Näherungsschalter mit Korrekturfaktor nahe oder gleich 1 realisieren.

**Patentansprüche**

1. Näherungsschalter mit einem Oszillator, der einen Parallelschwingkreis aus einem Kondensator (4) und einer ersten Spule (12), sowie einen Verstärker (8) aufweist, wobei letzterer eingangsseitig mit dem Parallelschwingkreis und ausgangsseitig über ein Rückkoppelelement (11) mit dem Parallelschwingkreis verbunden ist, und wobei der Schwingkreis einen als Schwingkreisimpedanz bei Resonanzfrequenz definierten Ersatzparallelwiderstand (14) aufweist, **dadurch gekennzeichnet, dass** zur ersten Spule (12) eine zweite Spule (13) in Reihe geschaltet ist, die gemeinsam einen induktiven Spannungsteiler bilden, dessen Mittenspannungsabgriff mit dem Eingang des Verstärkers (8) verbunden ist und dass das Rückkoppelelement (11) gegenüber dem Ersatzparallelwiderstand (14) niederohmig ausgeführt ist.

FIG 1

L

1
2
3

f

FIG 2

7
8
6
5
4
9
10

FIG 3

11
12
$R_{L1}$
8
4
14
$U_1$
13
$U_2$
$R_{L2}$
9
10

**Europäisches**
**Patentamt**

## EUROPÄISCHER RECHERCHENBERICHT

Nummer der Anmeldung

EP 06 11 5193

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 196 11 810 A1 (GEBHARD BALLUFF GMBH & CO., 73765 NEUHAUSEN, DE; GEBHARD BALLUFF GMBH) 2. Oktober 1997 (1997-10-02) * Seite 4, Zeile 16 - Seite 6, Zeile 12; Abbildungen 1,2 * ----- | 1 | INV. H03K17/95 |
| A | US 4 879 531 A (TIGGES ET AL) 7. November 1989 (1989-11-07) * Spalte 4, Zeilen 3-26; Abbildung 6 * ----- | 1 | |

RECHERCHIERTE
SACHGEBIETE (IPC)

H03K

Der vorliegende Recherchenbericht wurde für alle Patentansprüche erstellt

| Recherchenort | Abschlußdatum der Recherche | Prüfer |
|---|---|---|
| München | 9. August 2006 | Moll, P |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
...........................................................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 06 11 5193

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-08-2006

| Im Recherchenbericht angeführtes Patentdokument | | | Datum der Veröffentlichung | Mitglied(er) der Patentfamilie | | Datum der Veröffentlichung |
|---|---|---|---|---|---|---|
| DE 19611810 | A1 | | 02-10-1997 | KEINE | | |
| US 4879531 | A | | 07-11-1989 | DE | 3714433 C1 | 24-11-1988 |
| | | | | EP | 0288921 A2 | 02-11-1988 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4031252
- DE 3919916
- DE 4330140

**In der Beschreibung aufgeführte Nicht-Patentliteratur**

- *Fachbuch von Tietze-Schenk,* 1983, 441